# EUROPEAN PATENT APPLICATION

(11) **EP 1 970 960 A2**
(43) Date of publication of application: **17.09.2008**
(21) Application number: 08004157.7
(22) Date of filing: 06.03.2008
(51) Int. Cl.: H01L 27/32

(54) **Organic EL light emitting device and method for manufacturing the same**

(30) Priority: 15.03.2007 JP 2007066073
(71) Applicant: Yamagata Promotional Organization for Industrial Technology, Yamagata-shi, Yamagata 990-2473 (JP)
(72) Inventor: Kawai, Takashi, Yamagata-shi Yamagata 990-2473 (JP); Suzuki, Joji, Yamagata-shi Yamagata 990-2473 (JP)
(74) Representative: HOFFMANN EITLE

(57) **Abstract**

An organic EL light emitting device, in which a plurality of divided light emitting segments are connected in series, is efficiently manufactured without separate coating of organic EL light emitting layers with the use of a vapor-deposition mask. Conductor parts 5 are respectively formed on first electrodes 2b and 2c in boundary parts of adjacent light emitting segments a, b and c. Organic light emitting layers 3a to 3c and second electrode 4a to 4c are respectively stacked on each of the first electrode 2a to 2c. The conductor part 5 has a function for electrically connecting the first electrodes and the second electrodes in the adjacent light emitting segments, whereby the light emitting segments are connected in series.

## Description

### Field of the Invention

The present invention relates to an organic EL light emitting device using organic EL (electroluminescence) element which is a surface light emitting source having a relatively large area, and a method for manufacturing the organic EL light emitting device.

### Description of the Related Art

An organic EL element is driven at a direct current low voltage, thus can provide a high light-emitting efficiency, and at the same time, can realize the reduction of the weight and thickness, whereby the organic EL element is used in a flat panel display (FPD) in some portable apparatuses and the like. In addition, there is provided one in which an organic EL element as a surface light emitting source is used for, for example, a backlight for a liquid crystal display element.

Meanwhile, the organic EL element can provide each light emitting color of R (red), G (green) and B (blue) by the selection of a material used for an EL light emitting layer, and therefore, one or more than two kinds of the light emitting colors R, G and B can provide a white color or a light emitting color close to the white color. Therefore, the organic EL element is constituted as a surface light emitting source (light emitting panel) having a relatively large area, so that it can be used for a light-emitting poster for advertisement, electric spectaculars, and a light source for a sign, and in addition, used as a highly efficient light source for illuminating a room, a car interior, and the like.

In the organic EL element, a direct current voltage is applied between counter electrodes to recombine an electron injected from a cathode electrode and a hole injected from an anode electrode with each other in the light emitting layer, whereby a fluorescent material is excited by the energy of the recombination to generate light. Thus, it is necessary to take out to the outside the light emitted from the light emitting layer, and therefore, a transparent electrode is used for at least one electrode. As the transparent electrode, indium tin oxide (ITO) or the like is normally used.

The transparent electrode formed of ITO is then basically film-formed on a transparent substrate, and the EL light emitting layer formed from, for example, a hole transport layer, an organic light emitting layer, and an electron injection layer is formed on the transparent electrode, and then a metal electrode is further stacked on the EL light emitting layer. In this laminated structure, in general, the transparent electrode constitutes the anode, while the metal electrode constitutes the cathode, and thus the direct current voltage is applied between the both electrodes.

The above-mentioned ITO constituting the transparent electrode has electrical resistivity of about 1 × 10⁻⁴Ω cm, which is one or two figures higher than that of normal metal materials. Thus, as described above, when the EL element is constituted as a surface light emitting source having a large area, unevenness in light emission luminance (luminance gradient) occurs due to the voltage drop in the transparent electrode.

Namely, the light emission luminance in the organic EL element is said to be approximately proportional to the amount of the current injected onto a unit area of the organic EL element. Accordingly, the further from a feeding point with respect to the transparent electrode, the more significant the influence of the voltage drop due to ITO is, causing a problem that the luminance is darker as the further from the feeding point with respect to the transparent electrode.

In order to solve the above problem, there are some proposed materials having low electrical resistivity in the transparent electrode represented by ITO. However, it does not go far enough to drastically lower the electrical resistivity. Therefore, when the organic EL element is constituted as the surface light emitting source having a large area suitable for use in an illumination for example, there still remains a problem of the occurrence of the unevenness in the light emission luminance (luminance gradient), as described above.

Therefore, for example, Japanese Patent Applications Laid-Open Nos. 2000-29404 (Patent Document 1) and 2004-234868 (Patent Document 2) disclose an organic EL light emitting device having a constitution that an organic EL element with a large area is divided into a plurality of light emitting segments with a small area, and each of the light emitting segments is electrically connected in series, whereby the occurrence of the unevenness in the light emission luminance due to the voltage drop in the transparent electrode is prevented.

FIG. 9 shows a basic constitution of the organic EL light emitting device disclosed in the Patent Documents 1 and 2, and shows schematically a laminated structure example of the organic EL light emitting device provided with the light emitting segments which are provided by dividing the organic EL element into three parts.

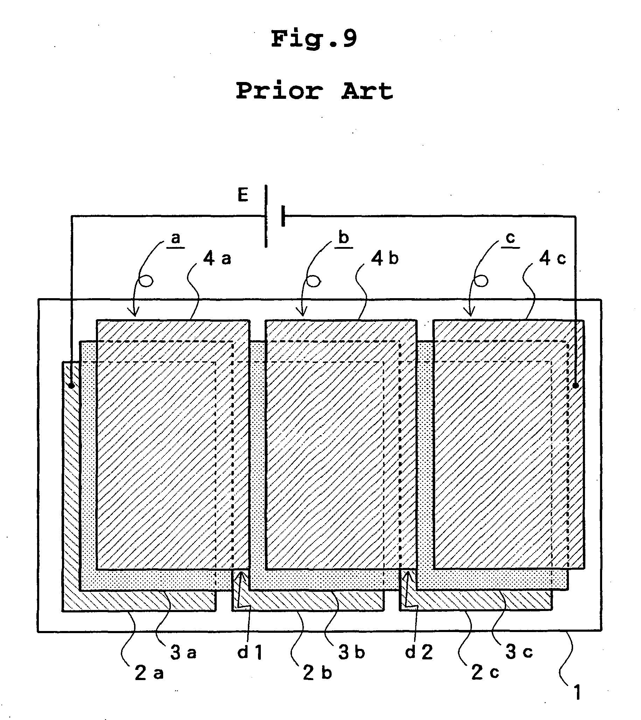

In FIG. 9, reference numeral 1 represents a substrate formed of a transparent material such as glass. The substrate 1 on the upper surface has a transparent electrode, which is a first electrode and is formed of, for example, ITO. ITO has been film-formed on the substrate 1 by vapor deposition or the like, and thereafter, the transparent electrode is divided (subjected to patterning) into three vapor deposition films 2a, 2b and 2c shown in FIG. 9 by using a photolithographic method for example.

In addition, three divided organic EL light emitting layers 3a, 3b and 3c are film-formedby the vapor deposition for example so as to be respectively stacked on the three divided transparent electrodes 2a, 2b and 2c. Further, three divided metal counter electrodes 4a, 4b and 4c, which are second electrodes, are formed on each of the organic EL light emitting layers 3a, 3b and 3 by the vapor deposition, for example.

Thereby, the transparent electrode 2a, the organic EL light emitting layer 3a and the counter electrode 4a constitute a first light emitting segment a, and likewise the transparent electrode 2b, the organic EL light emitting layer 3b and the counter electrode 4b constitute a second light emitting segment b. In a similar manner, the transparent electrode 2c, the organic EL light emitting layer 3c and the counter electrode 4c constitute a third light emitting segment c.

In this case, the end part of the counter electrode 4a constituting the first light emitting segment a is film-formed to be electrically conducted to the end part of the transparent electrode 2b constituting the second light emitting segment b through an overlapped part d1, while the end part of the counter electrode 4b constituting the second light emitting segment b is film-formed to be electrically conducted to the end part of the transparent electrode 2c constituting the third light emitting segment c through an overlapped part d2. Accordingly, the first to third light emitting elements are electrically connected in series.

Subsequently, a direct-current power supply E functioning as a light emission driving source is connected between the transparent electrode 2a constituting the first light emitting segment a and the counter electrode 4c constituting the third light emitting segment c. Namely, in the constitution shown in FIG. 9, a positive electrode terminal (+) of the direct-current power supply E is connected to the transparent electrode 2a, while the negative electrode terminal (-) of the direct-current power supply E is connected to the counter electrode 4c, whereby a light emission driving current is supplied to the first to third light emitting segments connected in series by the direct-current power supply E.

According to the above constitution, the organic EL element with a large area is divided into a plurality of parts (three parts in FIG. 9) to be connected in series, whereby the degree of generation of the unevenness in the light emission luminance can be effectively reduced due to the influence of high electrical resistivity in the transparent electrode represented by, for example, ITO.

In the organic light emitting EL device with a constitution that a plurality of light emitting segments a to c shown in FIG. 9 are connected in series, the organic EL light emitting layers 3a, 3b and 3c and the counter electrodes 4a, 4b and 4c constituting each light emitting segment should be separately coated (vapor-deposited) for each film-forming region by using a vapor-deposition mask.

Namely, it is necessary to film-form the organic EL light emitting layers 3a, 3b and 3c so that the overlapped parts d1 and d2 are not covered with the organic EL light emitting layers 3a and 3b by using the vapor-deposition mask. If the organic EL light emitting layers 3a and 3b cover the overlapped parts d1 and d2, the end parts of the counter electrodes 4a and 4b cannot be electrically conducted to the end parts of the adjacent transparent electrodes 2b and 2c, whereby it becomes impossible to connect each light emitting segment in series.

Meanwhile, when the counter electrodes 4a, 4b and 4c are film-formed on each organic EL light emitting layer, it is necessary to surely separate the counter electrodes 4a, 4b and 4c with the use of the vapor-deposition mask, and at the same time, the endparts of the counter electrodes 4a and 4b are required to be surely stacked on the end parts of the adjacent transparent electrodes 2b and 2c in the overlapped parts d1 and d2. In this case, the overlapped parts d1 andd2 arenon-light emitting parts, and thus, the width is desirably as small as possible, especially is 0.5 mm or smaller.

As mentioned above, when the organic EL light emitting layers and the counter electrodes are coated for each film-forming region with the use of the vapor-deposition mask, there arises a problem that the accuracy of vapor deposition pattern is deteriorated due to the infiltration of vapor deposition gas. If the pattern accuracy is deteriorated, there also arises a problem that the uniformity in the light emission is lost, or the transparent electrodes and the counter electrodes may be short-circuited.

Furthermore, the coating with the use of the vapor-deposition mask in a relatively large area renders the distortion of the mask large, whereby the vapor deposition accuracy is further deteriorated. Even if a magnet or the like is used for adhering the vapor-deposition mask to the substrate, there occurs a problem that a stripe with a small width (the stripe of 0.5 mm or smaller in width) for partitioning the vapor deposition region is twisted due to the wide opening of the vapor-deposition mask, whereby it is difficult to provide the necessary vapor deposition accuracy.

### SUMMARY OF THE INVENTION

The present invention has been made in view of the technical problems, and an object of the present invention is to provide an organic EL light emitting device, which has a plurality of divided light emitting segments connected in series and can be manufactured with high efficiency especially by omitting separate coating of organic EL light emitting layers with the use of a vapor-deposition mask, and a method for manufacturing the organic EL light emitting device.

In order to solve the above problems, an organic EL light emitting device according to the present invention has a constitution that a plurality of light emitting segments constituted of a first electrode, an organic EL light emitting layer and a second electrode are formed on a substrate, and connected in series. This organic EL light emitting device is characterized in that at least one conductor part is formed on the first electrode in a boundary part of the adjacent light emitting segments, and the organic EL light emitting layer and the second electrode are respectively stacked on each of the first electrodes, whereby the first electrode and the second electrode in the adjacent light emitting segments are electrically connected through the conductor part.

In this case, the height of the conductor part in the normal line direction of the substrate is desirably higher than the organic EL light emitting layer. In addition, the conductor part is preferably formed into a rectangular shape or an inverted trapezoidal shape in its cross-sectional surface, which is provided by cutting the surface of the substrate in the normal line direction.

In addition, in a preferable embodiment of the conductor part, the top part of the conductor part has concavoconvex parts of 10 nm to 10 µm at a P-V value. As a means for realizing such a constitution, a conductor paste is used for the conductor part, wherein the particle diameter of metal particles contained in the conductor paste is set to 1 nm to 10 µm.

Moreover, in a preferable embodiment of the organic EL light emitting device, the conductor part is formed in a partition form to be continuous along the boundary part of the adjacent light emitting segments.

Furthermore, in another preferable embodiment of the organic EL light emitting device, partition-like separators are further formed along the boundary parts of the light emitting segments so as to be respectively adjacent to the conductor parts of each of the light emitting segment, and an insulating gap part for electrically separating the second electrode for each of the light emitting segments is formed at an elementary part of the separator in the formation of the second electrode.

In this case, it is desirable that the upper part of the separator has an overhang part protruding in a direction parallel to a surface of the substrate.

Meanwhile, in a first method for manufacturing an organic EL light emitting device according to the present invention, the organic EL light emitting device has a constitution that a plurality of light emitting segments constituted of a first electrode, an organic EL light emitting layer and a second electrode are formed on a substrate and connected in series. The method for manufacturing an organic EL light emitting device has the steps of patterning for forming on the substrate the separated first electrodes in each of the light emitting segments, forming at least one conductor part on the first substrate in a boundary part of the adjacent light emitting segments on the substrate so as to be higher than an organic EL light emitting layer to be formed in the subsequent step, forming the organic EL light emitting layer on the first electrode, and forming the second electrode on the organic EL light emitting layer, whereby the first electrode and the second electrode between the adjacent light emitting segments can be electrically connected through the conductor part.

In addition, in a second method for manufacturing an organic EL light emitting device according to the present invention, the organic EL light emitting device has a constitution that a plurality of light emitting segments constituted of a first electrode, an organic EL light emitting layer and a second electrode are formed on a substrate and connected in series. The method for manufacturing an organic EL light emitting device has the steps of patterning for forming on the substrate the separated first electrodes in each of the light emitting segments, forming a continuous partition part along a boundary part of the adjacent light emitting segments on the substrate, forming the organic EL light emitting layer on the first electrode by obliquely vapor-depositing an organic EL light emitting material at a predetermined angle with respect to a normal line direction of the substrate, and forming the second electrode on the organic EL light emitting layer by vapor-depositing a second electrode material on the organic EL light emitting layer at a smaller angle than the predetermined angle, whereby the end part of the first electrode and the second electrode between the adjacent light emitting segments can be electrically connected through the conductor part.

In this case, it is desirable that the organic EL light emittingmaterial is obliquelyvapor-depositedbyusingan inline vapor-deposition apparatus.

According to the organic EL light emitting device and the first method for manufacturing the same of the present invention, the organic EL light emitting layer can be film-formed to cover the first electrode irrespective of the boundary part of the light emitting segments. Namely, it is unnecessary to separately coat the organic EL light emitting layer for each film-forming region with the use of a vapor-deposition mask as in the prior art. The second electrode is then film-formed on the organic EL light emitting layer to be able to be connected to the first electrode through the conductor part formed on the first electrode of the adjacent light emitting segments, whereby an organic EL light emitting device in which the light emitting segments are connected in series can be obtained.

In addition to this, thepartition-like separator is formed along the boundary part of the light emitting segments so as to be respectively adjacent to the conductor part of each light emitting segments, so that the second electrode can be film-formed to cover the organic EL light emitting layer irrespective of the boundary part of the light emitting segments. Namely, the partition-like separator is formed beforehand, so that the insulating gap part for electrically separating the second electrode for each light emitting segment can be formed in an elementary part of the separator when the second electrode is film-formed.

According to the first method for manufacturing the organic EL light emitting device, it is unnecessary to separately coat the second electrode for each film-forming region with the use of the vapor-deposition mask as in the prior art, whereby the productivity can be substantially enhanced, coupled with the film formation of the organic EL light emitting layer without the use of the vapor-deposition mask.

Meanwhile, in the second method for manufacturing an organic EL light emitting device according to the present invention, the continuous partition part is formed along the boundary part of the light emitting segment after the film formation of the first electrode, and then the organic EL light emitting material is obliquely vapor-deposited at a predetermined angle with respect to the normal line direction of the substrate. Thereby, the organic EL light emitting material can be film-formed in a separated state in accordance with the light emitting segments by the action of the partition part and the oblique vapor deposition.

Subsequently, the second electrode is formed on the organic EL light emitting layer, whereby the end part of the second electrode can be film-formed to be stacked on the end part of the first electrode in between the adjacent light emitting segments, so that the organic EL light emitting device in which the light emitting segments are electrically connected in series can be obtained.

### BRIEF DESCRIPTION OF THE DRAWINGS

FIG. 1 is an overhead schematic view of a laminated structure example of an organic EL light emitting device according to the present invention;
FIG. 2 is a cross-sectional view of the laminated structure of the organic EL light emitting device as viewed from a line A-A in a direction of arrow in FIG. 1;
FIGS. 3A is a cross-sectional view showing a state that a first electrode is subjected to patterning in a process for manufacturing the organic EL light emitting device shown in FIG. 1;
FIG. 3B is a cross-sectional view showing a state that conductor parts are formed subsequent to FIG. 3A;
FIG. 3C is a cross-sectional view showing a state that insulating layers are formed subsequent to FIG. 3B;
FIG. 3D is a cross-sectional view showing a state that separators are formed subsequent to FIG. 3C;
FIG. 3E is a cross-sectional view showing a state that organic EL light emitting layers are stacked subsequent to FIG. 3D;
FIG. 3F is a cross-sectional view showing a state that second electrodes are film-formed subsequent to FIG. 3E;
FIG. 4 is a partial enlarged cross-sectional view of a part surrounded by a chain line B in FIG. 3F;
FIG. 5 is a partial enlarged cross-sectional view showing another preferable constitution example of an organic EL light emitting device according to the present invention;
FIG. 6 is a partial enlarged cross-sectional view explaining another preferable method for manufacturing an organic EL light emitting device according to the present invention;
FIG. 7 is a schematic view showing an example of an inline vapor-deposition apparatus suitable for manufacturing the organic EL light emitting device in FIG. 6;
FIG. 8 is a cross-sectional view of the inline vapor-deposition apparatus as viewed from a line D-D in a direction of arrow in FIG. 7; and
FIG. 9 is an overhead schematic view of a laminated structure example of the prior art organic EL light emitting device.

### DESCRIPTION OF THE PREFERRED EMBODIMENTS

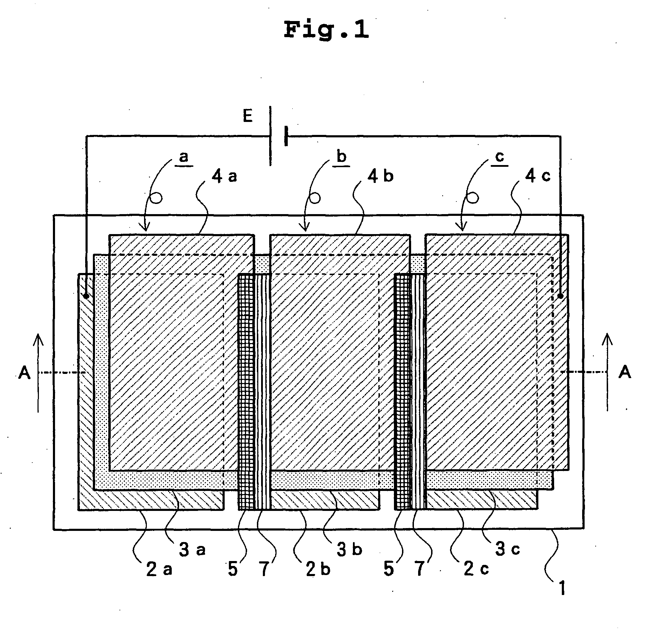

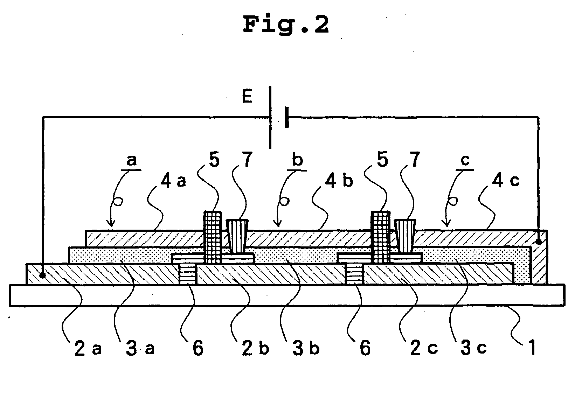

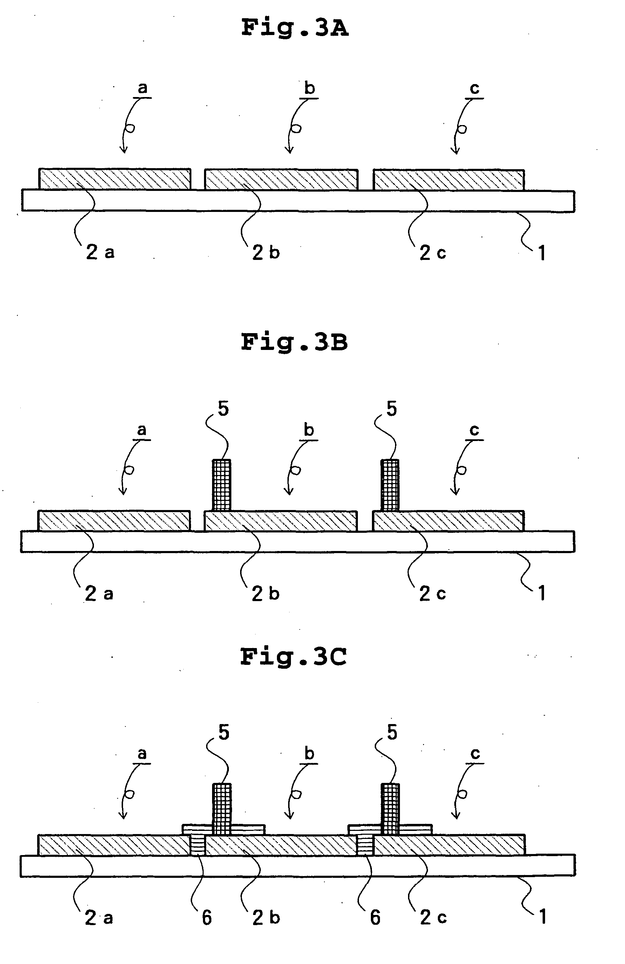

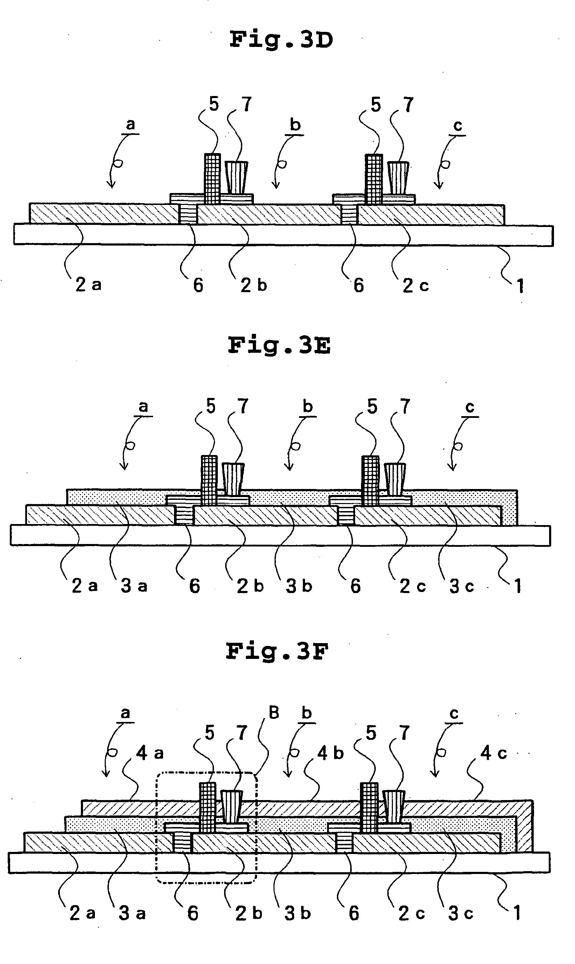

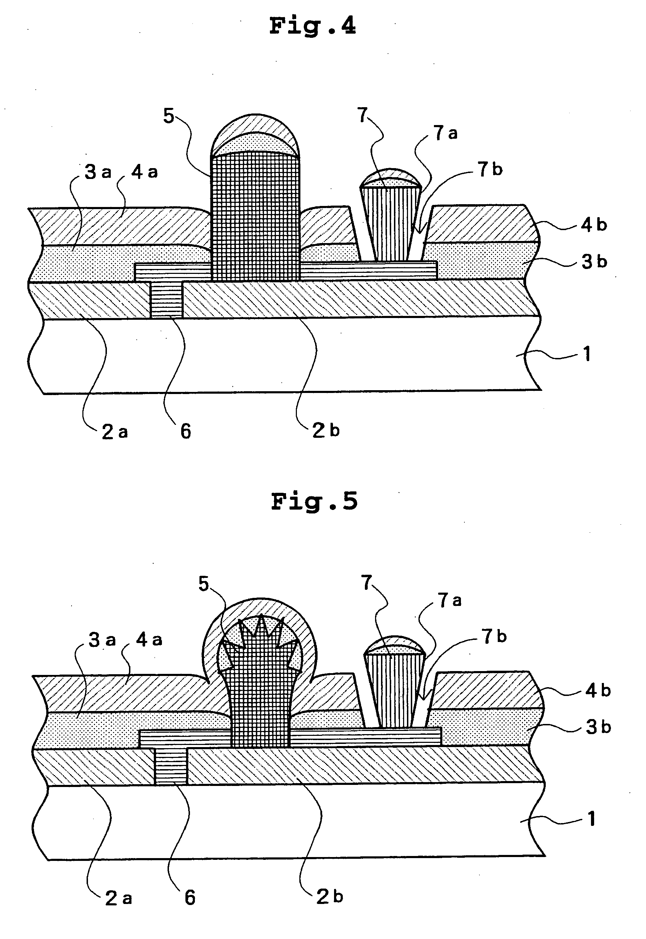

Hereinafter, an organic EL light emitting device according to the present invention is described based on the embodiments shown in the drawings. FIGS. 1 to 4 show the first embodiment. FIG. 1 is an overhead schematic view of a laminated structure example of an organic EL light emitting device provided with three-divided light-emitting segments. FIG. 2 is a cross-sectional view of the laminated structure example of the organic EL light emitting device as viewed from a line A-A in a direction of arrow in FIG . 1. FIGS. 3A to 3F are cross-sectional views showing the order of an example of a process for manufacturing (film-forming) the organic EL light emitting device shown in FIGS. 1 and 2. FIG. 4 is a partial enlarged cross-sectional view of a part surrounded by a chain line B in FIG. 3F. In each drawing to be explained hereinafter, components having the same function as the above-described components in FIG. 9 are represented by same numbers, and thus the detailed description is omitted.

As shown in FIGS. 1 and 2, an organic EL light emitting device of this embodiment has conductor parts 5 respectively formed on first electrodes 2b and 2c in boundary parts of each of light emitting segments a, b, and c. The conductor parts 5, as an example, are formed into a partition form so as to be continuous along the boundary part of each of the light emitting segments a, b and c in the boundary part. In addition, in this embodiment, insulating layers 6 are respectively formed between each of the light emitting segments a, b and c, and then, partition-like separators 7 are respectively formed along on the insulating layers 6 so as to be adjacent to the conductor part 5.

As mentioned above, the organic EL light-emitting layer is film-formed on the entire surface in a state that the conductor parts 5 and the partition-like separators 7 are formed. At this time, the organic EL light emitting layer is divided into three parts 3a, 3b and 3c by the conductor parts 5 and the partition-like separators 7 such that the organic EL light emitting layers 3a, 3b and 3c correspond to each of the light emitting segments a, b and c.

A metal counter electrode as a second electrode is further film-formed on the entire surface of the organic EL light emitting layer. At this time, the counter electrode is divided into three parts 4a, 4b and 4c by the separator 7 such that the counter electrodes 4a, 4b and 4c correspond to each of the light emitting segments a, b and c, and the counter electrodes 4a, 4b and 4c are film-formed in an insulated state, as describedhereinafter.

In accordance with the film formation of the counter electrodes 4a, 4b and 4c, the counter electrode 4a constituting the light emitting segment a is electrically connected to the transparent electrode 2b, which is the first electrode constituting the adjacent light emitting segment b, through the conductor part 5. Likewise, the counter electrode 4b constituting the light emitting segment b is electrically connected to the transparent electrode 2c, which is the first electrode constituting the adjacent light emitting segment c, through the conductor part 5. Thereby, it is possible to obtain an organic EL light emitting device in which the light emitting segments a, b and c are connected in series.

A direct-current power supply E functioning as a light emission driving source is connected between the transparent electrode 2a constituting the light emitting segment a and the counter electrode 4c constituting the light emitting segment c. Namely, in the constitution shown in FIG. 1, a positive electrode terminal (+) of the direct-current power supply E is connected to the transparent electrode 2a, while a negative electrode terminal (-) of the direct-current power supply E is connected to the counter electrode 4c, whereby a light emission driving current from the direct-current power supply E is supplied to the light emitting segments a, b and c connected in series.

A manufacturing (film-forming) method for obtaining the organic EL light emitting device shown in FIGS . 1 and 2 is described based on FIGS. 3A to 3F. FIG. 3A shows a state that the transparent electrodes 2a, 2b and 2c functioning as the first electrode are formed on a substrate 1 formed of a transparent material such as glass. These transparent electrodes 2a, 2b and 2c can be formed by film formation on the substrate 1 with a normal method such as a sputtering method, ion plating method, and vapor deposition method.

Although ITO can be suitably used for the transparent electrodes 2a, 2b and 2c as described above, a metal oxide such as indium zinc oxide and zinc oxide can be used therefor. The film thickness of the transparent electrode is set to 80 to 400 nm, preferably, 100 to 200 nm for the purpose of ensuring the transparency and conductivity. The transparent electrode can be patterned into three electrodes as indicated with the transparent electrodes 2a, 2b and 2c in FIG. 3A by using, for example, a photolithographic method after the film formation on the entire surface of the substrate 1.

Subsequently, the conductor parts 5 are formed as shown in FIG. 3B. As described above, the conductor parts 5 are formed in a partition form on the transparent electrodes 2a, 2b and 2c in the boundary parts of each of the adjacent light emitting segments a, b and c so as to be continuous along the boundary parts. The conductor parts 5 may not be formed in a continuous partition form. At least one conductor part may also be formed into a spot-like shape, for example, to be able to connect the light emitting segments a, b and c in series through the spot-like conductor part. However, the conductor part 5 formed in a partition form continuous along the boundary part as in this embodiment can more effectively compensate the high electrical resistivity in ITO, which is a first electrode material.

In the formation of the conductor parts 5, an etchingmethod, vacuum vapor deposition method, photolithographic method, printing method, and the like can be used. As a material used in the conductor 5, there are ITO, aluminum, photo silver paste, silver paste, carbon paste, and the like. In addition, the height of the conductor part 5 in the normal line direction of the substrate 1 is desirably higher than the organic EL light emitting layer to be formed later, optimally about 3 µm.

The conductor part 5 in its cross-sectional surface, which is provided by cutting the surface of the substrate 1 in the normal line direction, is desirably formed into a rectangular shape as shown in the drawings or into an inverted trapezoidal shape in which the width of the head is larger than the elementary part. The conductor part 5 may be formed by etching an integrally formed ITO or aluminum. The conductor part formed of a conductor paste (photo silver paste) can have an inverted trapezoidal cross-sectional surface by using a negative-type photolithographic method.

The cross-sectional surface of the conductor part 5 is formed into an inverted trapezoidal shape, whereby it is possible to lower the degree of adhesion of an insulating organic material to the side wall of the conductor part 5 in the formation of the organic EL light emitting layer to be described hereinafter. Thereby, it is possible to provide good electrical conduction in a back electrode with respect to the conductor part 5 in the further film formation of the back electrode to be described hereinafter.

FIG. 3C shows a state that the insulating layers 6 are formed between each of the light emitting segments a, b and c. As shown in FIG. 3C, the insulating layers 6 are formed between the transparent electrodes so as to contain the conductor part 5 thereinto so that its both sides follow the conductor part 5. As the insulating layer 6, for example polymeric polyimide can be used. The polymeric polyimide is coated to be exposed and developed, whereby the insulating layers 6 following the pattern shown in FIG. 3 can be formed.

FIG. 3D shows a process for forming the partition-like separators 7. The separators 7 are respectively formed along on the insulating layer 6 so as to be adjacent to each of the conductor parts 5. The upper part of the separator 7 has an overhang part 7a protruding in a direction parallel to the surface of the substrate 1 as enlarged in FIG. 4, whereby its cross-sectional surface is formed into an approximately inverted isosceles trapezoidal shape.

A preferable method for forming the separator 7 having an inverted isosceles trapezoidal cross-sectional surface is as follows. Namely, a negative photoresist in which permeability of a UV light is intentionally lowered is coated and prebaked. At this time, the thickness of the photoresist is set to about 2µm. The UV light is then projected and exposed to a position where the separator 7 is formed through a mask provided with a light transmission slit. At this time, since the photoresist has low transmittance of the UV light, the difference in solubility with respect to a developer is generated in the depth direction.

Thus, an alkaline developer is sprayed and showered on the substrate 1 in which the photoresist has been prebaked, whereby, as shown in FIG. 4, the separator 7 with the overhang part 7a is formed to protrude along on the insulating layer 6 due to the difference in progressing property of development. The cross-sectional surface of the separator 7 is formed into an approximately inverted isosceles trapezoidal shape, whereby the elementary part of the separator 7 can be provided with an insulating gap part 7b (shown in FIG. 4) for electrically separating the counter electrodes, which are the second electrodes, in each light emitting segment in the aftermentioned film formation of the counter electrodes.

FIG. 3E shows a state that the organic EL light emitting layer is further film-formed. In this case, the organic EL light emitting layer is film-formed on the entire surface, whereby the organic EL light emitting layer is divided into three parts 3a, 3b and 3c by the conductor parts 5 and the partition-like separators 7 such that the organic EL light emitting layers 3a, 3b and 3c correspond to each of the light emitting segments a, b, and c. Although the organic EL light emitting layer is basically constituted of a hole transport layer, an organic light emitting layer, and an electron-injection layer, in some cases, the organic EL light emitting layer is further provided with the hole injection layer and the electron-injection layer. The formation of these layers can adopt a normal method such as a vacuum vapor deposition method.

The film thickness of each of the above layers is determined according-to the condition in consideration of the applicability between each layer and the required entire thickness. The height of each of the three-divided organic EL light emitting layers 3a, 3b and 3c in the normal line direction of the substrate 1 is set to be lower than the height of the conductor part 5 and separator 7.

Subsequently, as shown in FIG. 3F, the counter electrode as the second electrode is further film-formed on the entire surfaces of the organic EL light emitting layers 3a, 3b and 3c. The counter electrode is film-formed into three separated parts 4a, 4b and 4c by the separator 7 so as to correspond to each of the light emitting segments a, b, and c.

The counter electrodes 4a, 4b and 4c are constituted of a metal, alloy and conductive compound having a small work function. For example, aluminum, aluminum-lithium alloy, magnesium-silver alloy, and the like are used. The film thickness of the counter electrodes is set to about 10 to 500 nm, preferably 50 to 200 nm. The counter electrodes can be also film-formed by a normal method such as a sputtering method, ion plating method, and vapor deposition method.

In this case, as shown in FIG. 4, the counter electrodes are film-formed not only on the organic EL light emitting layers 3a, 3b and 3c, but also on the organic material film-formed on the upper surfaces of the conductor part 5 and the separator 7 by the vapor deposition method. Here, as above described, the cross-sectional surface of the separator 7 is formed into an inverted isosceles trapezoidal shape containing the overhang part 7a, whereby the material for the counter electrode is prevented from being film-formed in the elementary part of the separator 7 in the film formation of the counter electrode.

As a result, the insulating gap part 7b can be formed in the elementary part of the separator 7 as shown in FIG. 4, whereby the counter electrodes are film-formed electrically separated as shown by the indicia 4a, 4b and 4c. Meanwhile, as shown in FIGS. 3F and 4, the counter electrode 4a is connected to the conductor part 5 in the film formation of the counter electrodes, and thus the counter electrode 4a is connected to the transparent electrode 2b through the conductorpart 5. Likewise, the counter electrode 4b is connected to the transparent electrode 2c through the conductor part 5, so that the light emitting segments a, b and c are connected in series.

As described above, according to the organic EL light emitting device of the present invention, the conductor parts are formed beforehand on the transparent electrode as the first electrode in the boundary parts of the adjacent light emitting elements, so that it is possible to provide an organic EL light emitting device having a constitution that the light emitting segments are connected in series without separate coating of the organic EL light emitting layer with the use of a vapor-deposition mask as in the prior art.

In addition, the partition-like separators are formed along the boundary parts of the light emitting segments so as to be adjacent to each of the conductor part, whereby the counter electrode can be film-formed in an electrically separated state so as to correspond to each of the light emitting segments without separate coating of the counter electrode as the second electrode with the use of the vapor-deposition mask as the prior art.

Accordingly, the organic EL light emitting device having the above mentioned constitution is adopted, so that it becomes possible to effectively manufacture the organic EL light emitting device with the divided plural light emitting segments connected in series.

In the process for manufacturing (film forming) the organic EL light emitting device explained based on FIGS. 3A to 3F, the conductor parts 5 are formed after patterning the transparent electrode as the first electrode, and then the insulating layers 6 and the separators 7 are formed. However, the insulating layers 6 and the separators 7 are formed after patterning the transparent electrode, and then conductor parts 5 may be formed.

In the organic EL light emitting device formed as mentioned above, when the electrical connection between the conductor part and the counter electrode is insufficient, a method as post-treatment after molding a panel can be adopted to ensure the connection between them, e.g., a method for applying reverse bias between the electrodes, a method for irradiating a laser onto the conductor part from the transparent electrode side or the counter electrode side (laser repair method), and a method for applying physical pressure from the counter electrode side to the conductor part.

FIG. 5 shows another preferable constitution example of an organic EL light emitting device according to the present invention. The components in FIG. 5 providing the same function as those described in FIG. 4 are represented by same numbers, and thus the detailed description is omitted.

In the example shown in FIG. 5, the conductor part 5 is formed by, for example, screen printing with the use of a conductive paste with a rough surface as a material for the conductor 5. In this case, the top part of the conductor part 5 desirably has concavoconvex parts of 10 nm to 10 µm at a P-V value. The concavoconvex parts are formed in the top part of the conductor part 5, and thus the connection between the conductive paste and the second electrode becomes ensured, whereby the electrical connection between them can be surely realized.

In this case, if the concavoconvex parts are less than 10 nm at the P-V value, since the organic layer exists as the insulating layer, the sure connection between the conductive paste and the second electrode is not expected. Meanwhile, if the concavoconvex parts are more than 10 nm at the P-V value, the organic layer may not be formed in the necessary part.

When the concavoconvex parts of 10 nm to 10 µm at the P-V value are formed in the top part of the conductor part 5 as mentioned above, the conductor paste containing the metal particles with a diameter of 1 nm to 10µm is selected and used, whereby the preferable result can be obtained.

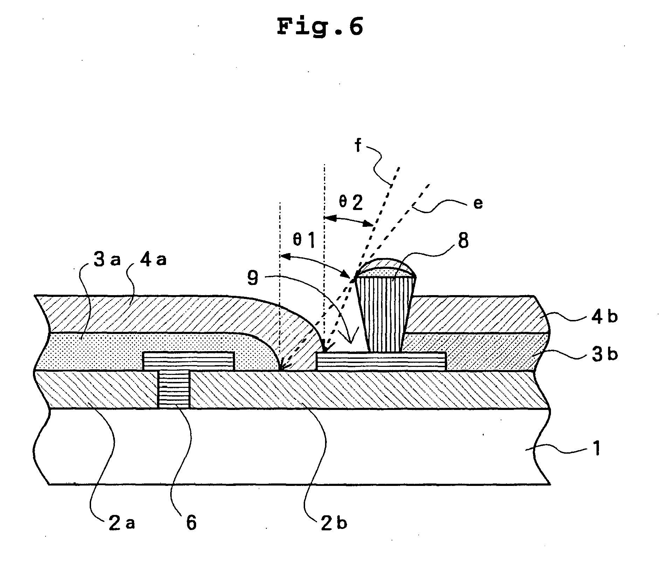

FIG. 6 explains another preferable method for manufacturing an organic EL light emitting device according to the present invention. In the constitution shown in FIG. 6, the components in FIG. 6 providing the same function as those described in FIG. 4 are represented by same numbers, and thus the detailed description is omitted.

In the organic EL light emitting device shown in FIG. 6, a continuous partition part 8 is formed along the boundary part of the adjacent light emitting segments on the substrate 1. Although the cross-sectional surface of the partition part 8 is formed into an approximately inverted trapezoidal shape as with the separator 7 described in FIG. 6, the cross-sectional surface of the partition part 8 may be formed into a rectangular or trapezoidal shape.

The organic EL light emitting material is then obliquely vapor-deposited in a state that the partition part 8 is formed, whereby the film formation position in the organic EL light emitting layer in theboundarypart of the light emitting segments are controlled. Namely, in the example shown in FIG. 6, the organic EL light emitting material is obliquely vapor-deposited onto the substrate 1 in a state shown by a dashed arrow e. At this time, the angle of the oblique vapor deposition with respect to the normal line direction of the substrate is θ1.

The organic EL light emitting material is obliquely vapor-deposited in the above mentioned state, whereby the organic EL light emitting layers 3a, 3b and 3c are film-formed so as to be stacked on the transparent electrodes 2a, 2b and 2c. At this time, the organic EL light emitting material is not vapor-deposited to the shadow part of the partition part 8. Subsequently, the second electrode material is vapor deposited onto the organic EL light emitting layers at an angle θ2 smaller than the angle θ1. Namely, the second electrode material is obliquely vapor-deposited onto the substrate 1 in a state shown by a dashed arrow f.

Thereby, the counter electrodes 4a and 4b are bonded to the end parts of the transparent electrodes 2b and 2c in the adjacent light emitting segments, and thus are electrically conducted. Meanwhile, the electrode material for the counter electrode is not obliquely vapor-deposited to the shadow part of the partition part 8, and thus an insulating gap part 9 is formed. Therefore, the counter electrodes are film-formed electrically separated in each light emitting segment by the insulating gap part 9.

Accordingly, also in the adoption of the oblique vapor deposition, it becomes possible to effectively manufacture the organic EL light emitting device with the divided light emitting segments connected in series.

As mentioned above, in the case in which the oblique vapor deposition is performed, in a cluster type of substrate rotation vapor deposition mechanism for example, when the angular limitation is provided, the vapor deposition unevenness occurs, whereby it is difficult to cope with a substrate with a large area. Therefore, an inline vapor-deposition apparatus is desirably used.

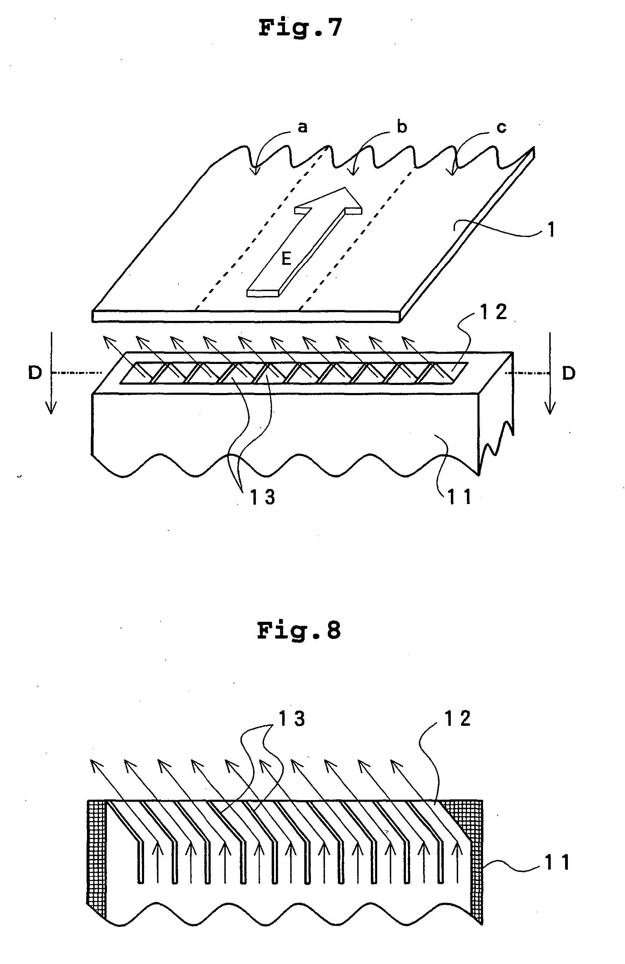

FIGS. 7 and 8 schematically show an example of an inline vapor-deposition apparatus which can be suitably adopted to the method for manufacturing the organic EL light emitting device with the use of the oblique vapor deposition shown in FIG. 6. FIG. 7 shows a feeding relation between the inline vapor-deposition apparatus anda substrate subj ected to the vapor deposition carried out by the inline vapor-deposition apparatus. FIG. 8 shows the inline vapor-deposition apparatus as viewed from a line D-D in a direction of arrow in FIG. 7.

The outline of the inline vapor-deposition apparatus 11 is formed into a rectangular solid shape, and the upper end part has a rectangular nozzle opening 12. The bottompart (not shown) of vapor-deposition apparatus 11 constitutes an evaporation chamber (crucible) accommodating a vapor deposition material therein. The vapor deposition material is heated by a heater (not shown), and thus is evaporated or sublimated, whereby the vapor is delivered through the nozzle opening 12.

In this case, a plurality of guide plates 13 are arranged in the rectangular nozzle opening 12. The guide plates 13 deliver the vapor toward one of the longitudinal direction of the nozzle opening 12 at a predetermined angle (θ1 or θ2) with respect to the vertical direction. Meanwhile, the substrate 1 is fed directly on the nozzle opening 12 at a constant speed in a direction perpendicular to the longitudinal direction of the nozzle opening 12, that is, in a direction of an arrow E.

In this case, the light emitting segments a, b and c are partitioned on the substrate 1 so as to be parallel to the feeding direction E. As mentioned above, it is possible to control a vapor deposition area of the organic EL light emitting material and the counter electrode material by the action of the partition part 8 formed in the boundary part of the light emitting segments as shown in FIG. 6.

In the above embodiments, the bottom emission type light emitting device, in which the first electrode on the substrate 1 side is the transparent electrode, is described as an example; however, the present invention can be similarly applied to a top emission type light emitting device in which the second electrode is the transparent electrode.

## Claims

1. An organic EL light emitting device, in which a plurality of light emitting segments constituted of a first electrode, an organic EL light emitting layer and a second electrode are formed on a substrate and connected in series, the device comprising:
at least one conductor part formed on the first electrode in a boundary part of the adjacent light emitting segments;
wherein the organic EL light emitting layer and the second electrode are respectively stacked on each of the first electrodes, whereby the first electrode and the second electrode in the adjacent light emitting segments are electrically connected through the conductor part.

2. The organic EL light emitting device as claimed in claim 1, wherein the height of the conductor part in the normal line direction of the substrate is higher than the organic EL light emitting layer.

3. The organic EL light emitting device as claimed in claim 1, wherein the conductor part is formed into a rectangular shape or an inverted trapezoidal shape in its cross-sectional surface, which is provided by cutting a surface of the substrate in the normal line direction.

4. The organic EL light emitting device as claimed in claim 2, wherein the conductor part is formed into a rectangular shape or an inverted trapezoidal shape in its cross-sectional surface, which is provided by cutting a surface of the substrate in the normal line direction.

5. The organic EL light emitting device, as claimed in any one of claims 1 to 4, wherein a top part of the conductor part has concavoconvex parts of 10 nm to 10 µm at a P-V value.

6. The organic EL light emitting device, as claimed in any one of claims 1 to 4, wherein the conductor part is formed of a conductor paste, a particle diameter of metal particles contained in the conductor paste is set to 1 nm to 10 µm.

7. The organic EL light emitting device as claimed in claim 5, wherein the conductor part is formed of a conductor paste, a particle diameter of metal particles contained in the conductor paste is set to 1 nm to 10 µm.

8. The organic EL light emitting device, as claimed in any one of claims 1 to 4, wherein the conductor part is formed in a partition form to be continuous along the boundary part of the adjacent light emitting segments.

9. The organic EL light emitting device as claimed in claim 5, wherein the conductor part is formed in a partition form to be continuous along the boundary part of the adjacent light emitting segments.

10. The organic EL light emitting device as claimed in claim 6, wherein the conductor part is formed in a partition form to be continuous along the boundary part of the adjacent light emitting segments.

11. The organic EL light emitting device as claimed in claim 7, wherein the conductor part is formed in a partition form to be continuous along the boundary part of the adjacent light emitting segments.

12. The organic EL light emitting device as claimed in claim 1, further comprising: apartition-like separator further formed along the boundary parts of the light emitting segments so as to be adjacent to the conductor part of each of the light emitting segments, wherein an insulating gap part for electrically separating the second electrode in each of the light emitting segments is formed in an elementary part of the separator in the formation of the second electrode.

13. The organic EL light emitting device as claimed in claim 12, wherein an upper part of the separator has an overhang part protruding in a direction parallel to a surface of the substrate.

14. A method for manufacturing an organic EL light emitting device, which has a constitution that a plurality of light emitting segments constituted of a first electrode, an organic EL light emitting layer and a second electrode are formed on a substrate and connected in series, the method comprising the steps of:
patterning for forming on the substrate the separated first electrodes in each of the light emitting segments;
forming at least one conductor part on the first substrate in a boundary part of adjacent light emitting segments on the substrate so as to be higher than an organic EL light emitting layer to be formed in the subsequent step;
forming the organic EL light emitting layer on the first electrode; and
forming the second electrode on the organic EL light emitting layer;
whereby the first electrode and the second electrode in between the adjacent light emitting segments can be electrically connected through the conductor part.

15. A method for manufacturing an organic EL light emitting device, which has a constitution that a plurality of light emitting segments constituted of a first electrode, an organic EL light emitting layer and a second electrode are formed on a substrate and connected in series, the method comprising the steps of:
patterning for forming on the substrate the separated first electrodes in each of the light emitting segments;
forming a continuous partition part along a boundary part of the adjacent light emitting segments on the substrate;
forming the organic EL light emitting layer on the first electrode by obliquely vapor-depositing an organic EL light emitting material at a predetermined angle with respect to a normal line direction of the substrate; and
forming the second electrode on the organic EL light emitting layer by vapor-depositing a second electrode material on the organic EL light emitting layer at a smaller angle than the predetermined angle;
whereby the end part of the first electrode and the end part of the second electrode in between the adjacent light emitting segments can be electrically connected through the conductor part.

16. The method for manufacturing an organic EL light emitting device as claimed in claim 15, wherein the organic EL light emitting material is obliquely vapor-deposited by using an inline vapor-deposition apparatus.
